# EUROPEAN PATENT APPLICATION

(11) **EP 2 157 835 A2**
(43) Date of publication of application: **24.02.2010**
(21) Application number: 09168047.0
(22) Date of filing: 18.08.2009
(51) Int. Cl.: H05B 41/282, H05B 41/285

(54) **Illumination device**

(30) Priority: 20.08.2008 TW 97131770
(71) Applicant: Gigno Technology Co., Ltd., Datong, Taipei City 103 (TW)
(72) Inventor: Sah, Wen-Jyh, Tainan City 700 (TW)
(74) Representative: 2K Patentanwälte Blasberg Kewitz & Reichel

(57) **Abstract**

An illumination device includes a first circuit board, a second circuit board and a lighting unit. The first circuit board has a controlling circuit, a switching circuit and a protection circuit. The controlling circuit is electrically connected to the switching circuit and the protection circuit, respectively. The second circuit board has a transforming circuit and is electrically connected with the first circuit board. The lighting unit and the transforming circuit are electrically connected.

## Description

### BACKGROUND OF THE INVENTION

### Field of Invention

The present invention relates to an illumination device.

### Related Art

Due to the progress of technology, various kinds of illumination devices have become one of the indispensable electronic products. In all kinds of the illumination devices, at least one driving circuit board is needed for providing a driving signal to drive the lighting unit in the illumination device. For example, the lighting unit can be a cold cathode fluorescent lamp (CCFL).

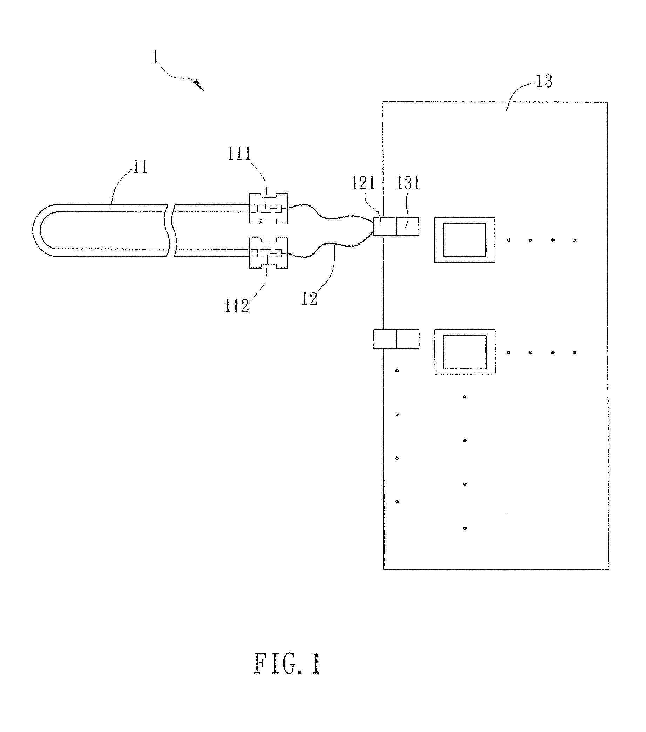

As shown in FIG. 1, a conventional illumination device 1 includes a CCFL 11, a connecting line 12 and a driving circuit board 13. The CCFL 11 is electrically connected to a connecting terminal 121 of the connecting line 12, which is high-voltage durable, through the electrodes 111 and 112, and then connected to a connecting terminal 131 of the driving circuit board 13 through the connecting terminal 121 of the connecting line 12.

Accordingly, the driving signal outputted from the driving circuit board 13 can be transmitted through the connecting terminals 131 and 121 and the connecting line 12 to drive the CCFL 11.

However, if the CCFL 11 is breakdown, the driving signal transmitted between the connecting terminals 131 and 121 may cause the electric shock when replacing the broken CCFL 11. In addition, if the connecting terminals 131 and 121 are not improperly connected after replacing the broken CCFL 11, or if the electronic connection is abnormal due to the repeated replacement of the CCFL, the undesired arcing or electric leakage may occur.

Therefore, it is an important subject to provide an illumination device that can be maintained easily and can avoid the undesired arcing or electric leakage.

### SUMMARY OF THE INVENTION

In view of the foregoing, the present invention is to provide an illumination device that can be maintained easily and can avoid the undesired arcing or electric leakage.

To achieve the above, the present invention discloses an illumination device including a first circuit board, a second circuit board and a lighting unit. The first circuit board has a controlling circuit, a switching circuit and a protection circuit, and the controlling circuit is electrically connected to the switching circuit and the protection circuit, respectively. The second circuit board has a transforming circuit and is electrically connected with the first circuit board. The lighting unit is electrically connected to the transforming circuit.

To achieve the above, the present invention also discloses an illumination device including a first circuit board, a second circuit board and a lighting unit. The first circuit board has a rectifying circuit and is electrically connected to the second circuit board. The second circuit board has a controlling circuit, a switching circuit and a transforming circuit electrically connected to each other. The lighting unit is electrically connected to the transforming circuit.

To achieve the above, the present invention further discloses an illumination device including a first circuit board, a second circuit board and a lighting unit. The first circuit board has a rectifying circuit and a controlling circuit electrically connected to each other. The second circuit board is electrically connected to the first circuit board and has a switching circuit and a transforming circuit electrically connected to each other. The lighting unit is electrically connected to the transforming circuit.

In addition, the present invention further discloses an illumination device including a first circuit board, a second circuit board and a lighting unit. The first circuit board has a rectifying circuit. The second circuit board is electrically connected to the first circuit board and has a transforming circuit. The lighting unit is electrically connected to the transforming circuit.

As mentioned above, the lighting unit is electrically connected to the transforming circuit of the second circuit board, and then the second circuit board is electrically connected to the first circuit board. Thus, if the lighting unit is breakdown, the replacement or repairing of the broken lighting unit can be performed by simply detaching the second and first circuit boards. This can avoid the user from contacting the driving signal transmitted between the transforming circuit and the lighting unit, so that the risk of electric shock during the replacement or repairing can be reduced.

Moreover, since the replacement or repairing can be performed by disconnecting or connecting the first and second circuit boards, the improper connection caused by improperly connecting of the first and second circuit boards or repeated replacement while directly replacing the lighting unit can be prevented. This can further avoid the undesired arcing or electric leakage due to the driving signal between the lighting unit and the second circuit board, thereby enhancing the reliability of the illumination device.

Furthermore, in the illumination device of the present invention, different circuits are separately configured at different circuit boards. This configuration can increase the efficiency of detecting the broken circuits. If only one circuit is damaged, it is not necessary to replace the entire circuit board, so that the maintain cost can be reduced. In addition, the illumination device of the present invention may further include a protection circuit for disabling the controlling circuit when the short circuit is happened between the first and second circuit boards. This can protect the illumination device from further damages as the switching circuit keeping outputting the power signal.

### BRIEF DESCRIPTION OF THE DRAWINGS

The invention will become more fully understood from the detailed description and accompanying drawings, which are given for illustration only, and thus are not limitative of the present invention, and wherein:

FIG. 1 is a schematic view of a conventional illumination device;

FIG. 2 is a block diagram of an illumination device according to a first embodiment of the present invention;

FIGS. 3A and 3B are schematic circuit diagrams showing different protection circuits according to the first embodiment of the present invention;

FIGS. 4A and 4B are schematic illustrations showing different aspects of the illumination device of the present invention;

FIGS. 5A and 5B are schematic illustrations showing different aspects of the illumination device of the present invention;

FIG. 6 is a schematic illustration showing another aspect of the illumination device of the present invention;

FIGS. 7A to 7C are schematic illustrations showing different connection types between a lighting unit and holding members of a carrier in the illumination device of the present invention;

FIG. 8 is a schematic illustration showing yet another aspect of the illumination device of the present invention;

FIG. 9 is a block diagram showing an illumination device according to a second embodiment of the present invention; and

FIG. 10 is a block diagram showing an illumination device according to a third embodiment of the present invention.

### DETAILED DESCRIPTION OF THE INVENTION

The present invention will be apparent from the following detailed description, which proceeds with reference to the accompanying drawings, wherein the same references relate to the same elements.

### FIRST EMBODIMENT

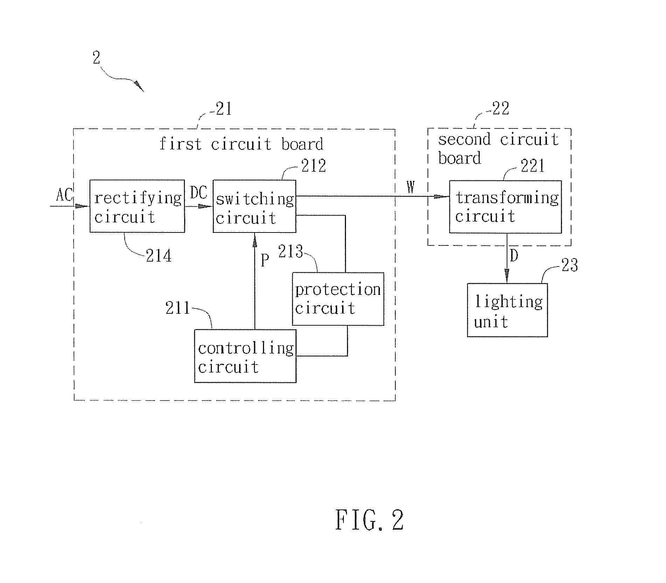

FIG. 2 is a block diagram of an illumination device 2 according to a first embodiment of the present invention. The illumination device 2 can be an indoor or outdoor illumination device. The indoor illumination device can be, for example, a desk light, a fluorescent light or a ceiling light, and the outdoor illumination device can be, for example, a street light, a multimedia light or a traffic light. As shown in FIG. 2, the illumination device 2 includes a first circuit board 21, a second circuit board 22 and a lighting unit 23.

The first circuit board 21 has a controlling circuit 211, a switching circuit 212 and a protection circuit 213. The controlling circuit 211 is electrically connected to the switching circuit 212 and the protection circuit 213, respectively. In the embodiment, the switching circuit 212 may contain a bipolar junction transistor (BJT) or a field-effect transistor (FET), and the protection circuit 213 can be a short circuit protection (SCP) circuit for example. In addition, the first circuit board 21 of this embodiment may, but not limited to, further include a rectifying circuit 214. For example, the rectifying circuit 214 may include a power factor correction (PFC) circuit, an AC-DC conversion circuit, a half-bridge rectifying circuit and/or a full-bridge rectifying circuit.

The second circuit board 22 has a transforming circuit 221 and is electrically connected to the first circuit board 21.

The lighting unit 23 is electrically connected with the transforming circuit 221 of the second circuit board 22. In the embodiment, the lighting unit 23 may include a light-emitting diode (LED) or a fluorescent lamp such as a hot cathode fluorescent lamp (HCFL) or a cold cathode fluorescent lamp (CCFL). Furthermore, the lighting unit 23 may further include the ballast (not shown) for steadying the driving signal received by the fluorescent lamp.

To be noted that the illumination device 2 can include a plurality of second circuit boards 22 and a plurality of lighting units 23. In this case, the first circuit board 21 is electrically connected with the second circuit boards 22, and each the second circuit board 22 is electrically connected to one lighting unit 23.

As mentioned above, the rectifying circuit 214 generates a power source signal DC according to the inputted alternate-current power source signal AC. In the embodiment, the alternate-current power source signal AC can be an AC power source of 85V to 300V and 42Hz to 72 Hz, and the power source signal DC can be a DC power source of about 400V. The switching circuit 212 receives the power source signal DC, and the controlling circuit 211 generates at least one control signal P according to the power source signal DC. The switching circuit 212 is opened or closed according to the control signal P generated by the controlling circuit 211, thereby outputting a power signal W to the transforming circuit 221. After receiving the power signal W, the transforming circuit 221 generates a driving signal D to the lighting unit 23 for driving the lighting unit 23 to emit light. In addition, if a short circuit is happened between the first and second circuit boards 21 and 22, the protection circuit 213 can disable the controlling circuit 21 so as to stop the switching 212 keeping outputting the power signal W.

Therefore, the lighting unit 23 can be repaired or replaced by detaching the first and second circuit boards 21 and 22. This can avoid the user from contacting the driving signal D transmitted between the transforming circuit 221 and the lighting unit 23, so that the risk of electric shock during the replacement or repairing can be reduced.

Moreover, since the replacement or repairing for the illumination device 2 can be performed by disconnecting or connecting the first and second circuit boards 21 and 22, the improper connection caused by improperly connecting of the first and second circuit boards 21 and 22 or repeated replacement while directly replacing the lighting unit 23 can be prevented. This can further avoid the undesired arcing or electric leakage due to the driving signal D between the lighting unit 23 and the second circuit board 22, thereby enhancing the reliability of the illumination device 2. Furthermore, in the illumination device 2 of the present embodiment, different circuits are separately configured at different circuit boards. This configuration can increase the efficiency of detecting the broken circuits. If only one circuit is damaged, it is not necessary to replace the entire circuit board, so that the maintain cost can be reduced.

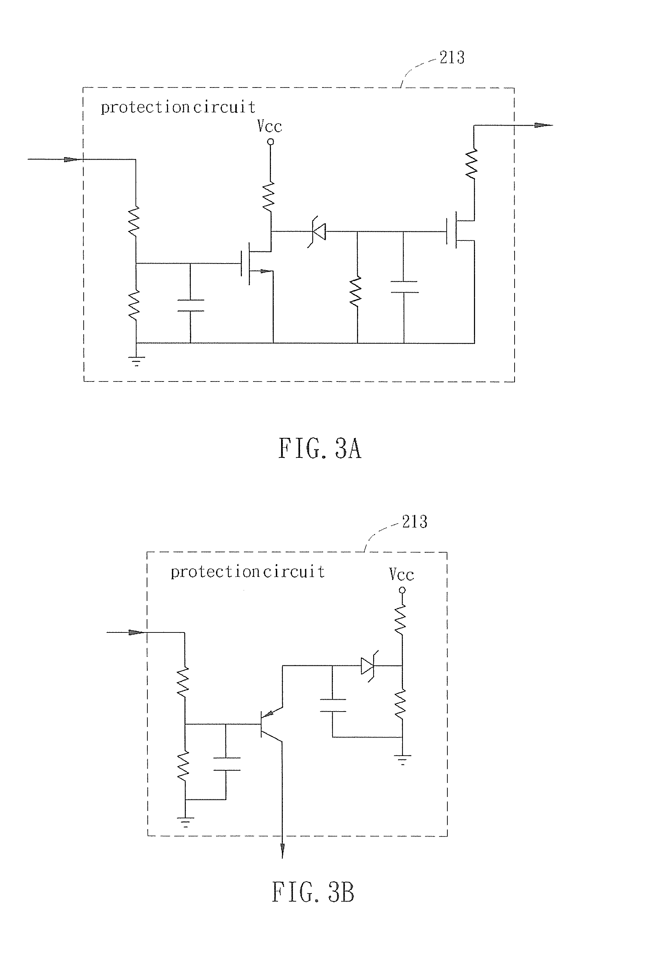

In addition, the illumination device 2 of the present embodiment further includes the protection circuit 213 for disabling the controlling circuit 211 when the short circuit is happened between the first and second circuit boards 21 and 22. This can protect the illumination device 2 from further damages as the switching circuit 212 keeping outputting the power signal W. The circuit designs of the protection circuit 213 are shown in FIGS. 3A and 3B for example, wherein Vcc represents the power source. To be noted, the circuit design of the protection circuit 213 is not limited to these, and it can be other configurations due to different demands.

Several aspects of the illumination device according to the present embodiment will be described herein below with reference to the related drawings.

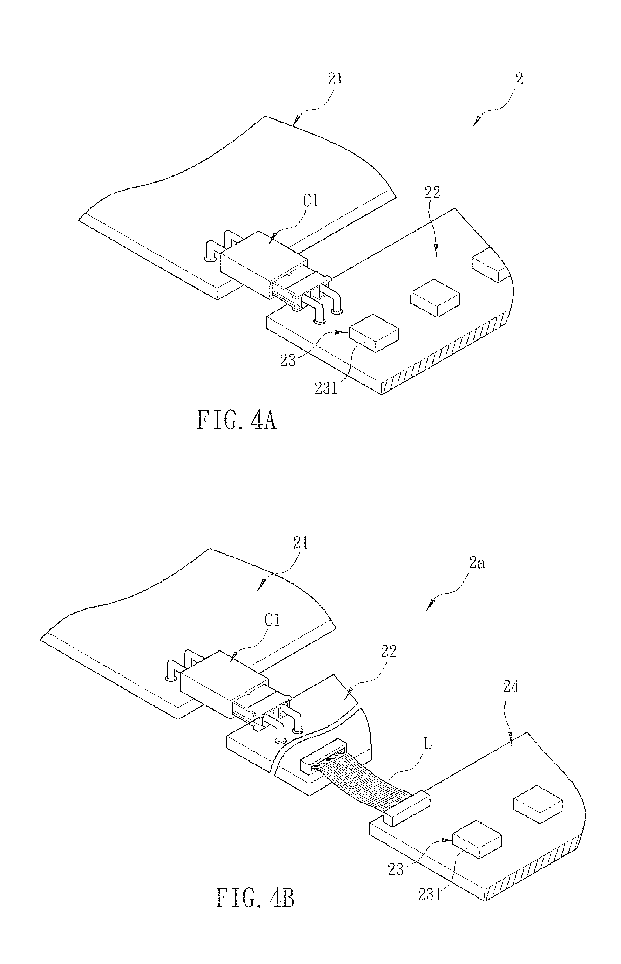

FIG. 4A is a schematic illustration showing an aspect of the illumination device 2, wherein the lighting unit 23 includes LEDs 231 for example. With reference to FIG. 4A, the LEDs 231 are disposed on the second circuit board 22, and the second circuit board 22 is electrically connected to the first circuit board 21 through a connector C1.

Accordingly, the repairing or replacement of the lighting unit 23 can be performed by simply detaching the connector C1 between the first and second circuit boards 21 and 22. Thus, the efficiency of the repairing or replacement of the illumination device 2 can be sufficiently enhanced so as to increase the convenience thereof.

FIG. 4B is a schematic illustration showing an illumination device 2a, which is another aspect of the embodiment. With reference to FIG. 4B, in the illumination device 2a, the LEDs 231 of the lighting unit 23 are disposed on the third circuit board 24, which is connected to the second circuit board 22 by welding or through a conductive wire or a connector. In this aspect, the third circuit board 24 is connected to the second circuit board 22 through a conductive wire L.

In this aspect, a portion of the controlling circuits for the LEDs 231 can be disposed on the third circuit board 24 so as to decrease the circuit complexity of the second circuit board 22 and reduce the production cost. Similarly, the repairing or replacement of the lighting unit 23 can be performed by simply detaching the first and second circuit boards 21 and 22. Thus, the efficiency of the repairing or replacement of the illumination device 2a can be sufficiently enhanced so as to increase the convenience thereof.

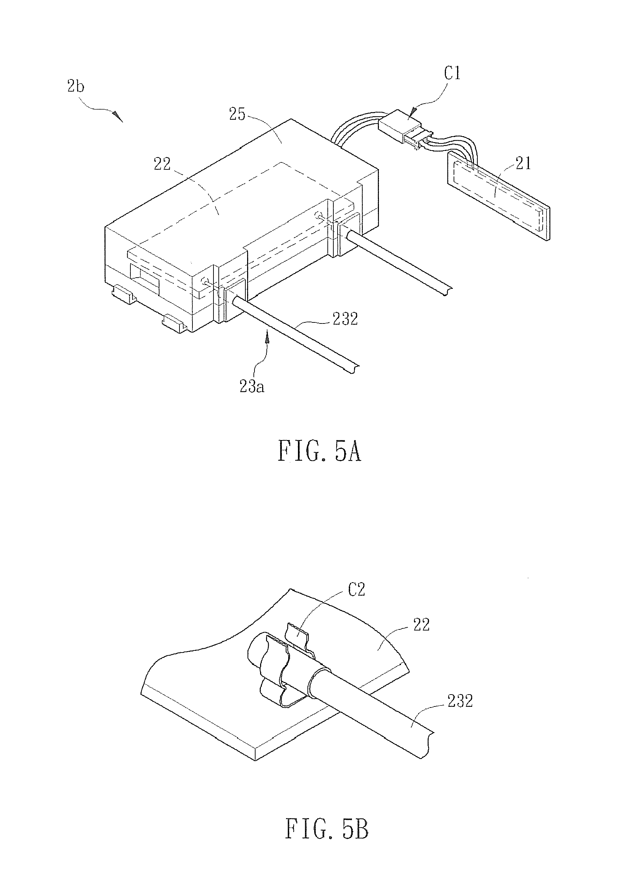

FIG. 5A is a schematic illustration showing an illumination device 2b, which is another aspect of the embodiment. With reference to FIG. 5A, the illumination device 2b further includes an insulating housing 25, and at least one portion of the second circuit board 22 is located in the insulating housing 25. The first circuit board 21 can be disposed within another housing or be suspended. In this aspect, the second circuit board 22 is completely disposed in the insulating housing 25, and the first circuit board 21 is disposed in another housing. In addition, the insulating housing 25 further includes a connector C1 for electrically connecting the first circuit board 21 and the second circuit board 22. The insulating housing 25 may have a reflective surface, which is formed by a white coating material or reflective layer, for increasing the light utilization rate of the lighting unit 23a.

In this aspect, the lighting unit 23a includes fluorescent lamps 232 for example. The fluorescent lamp 232 can be a HCFL or a CCFL, and it may be U-shaped, W-shaped, C-shaped or linear. In this embodiment, the fluorescent lamp 232 is a U-shaped CCFL with a total length larger than 90 cm.

The fluorescent lamp 232 is connected to the second circuit board 22 by welding (as shown in FIG. 5A) or through a conductive wire or a connector C2 (as shown in FIG. 5B).

Referring to FIG. 5A again, it is noted that the second circuit board 22 may drive a plurality of U-shaped fluorescent lamps, C-shaped fluorescent lamps, W-shaped fluorescent lamps or linear fluorescent lamps, or it may drive a single U-shaped fluorescent lamp, a single C-shaped fluorescent lamp, a single W-shaped fluorescent lamp or two linear fluorescent lamps. In this aspect, the second circuit board 22 drives a single U-shaped fluorescent lamp for example.

In the embodiment, since the insulating housing 25 covers the second circuit board 22, the user can be avoided from contacting the driving signal between the transforming circuit 221 and the fluorescent lamp 232, and will not get hurt by the driving signal. Thus, the electric shock can be prevented when the user performing the repairing or replacement. In addition, the first circuit board 21 and the second circuit board 22 are connected through the connector C1, so that the efficiency of the repairing or replacement of the illumination device 2b can be sufficiently enhanced so as to increase the convenience thereof.

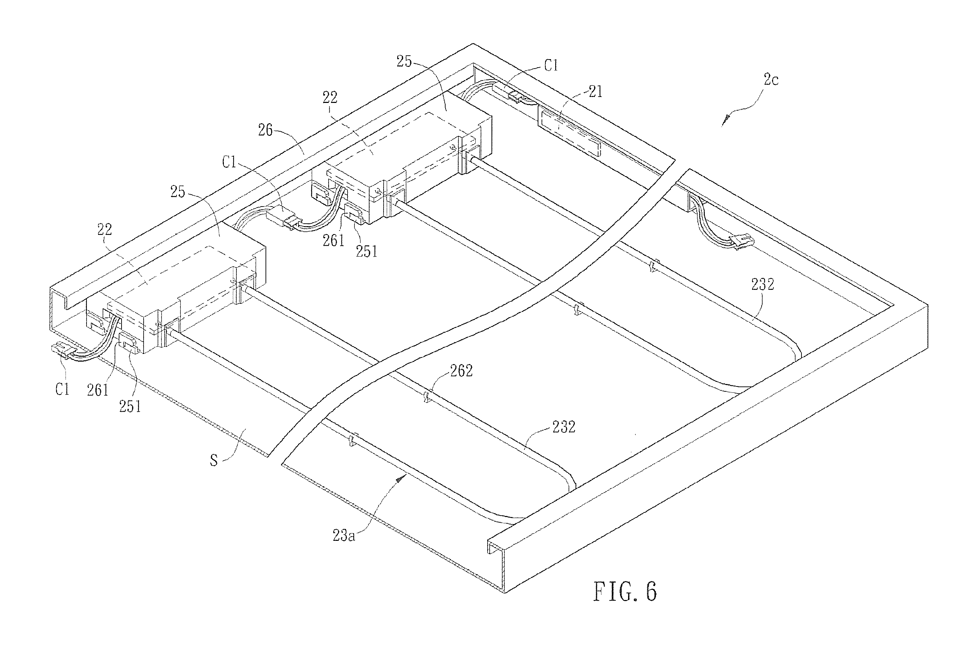

FIG. 6 is a schematic illustration showing an illumination device 2c, which is another aspect of the embodiment. With reference to FIG. 6, the illumination device 2c further includes a carrier 26, and there are a plurality of second circuit boards 22, lighting units 23a and insulating housings 25 are configured in the illumination device 2c. The second circuit boards 22 are connected through connectors C1. The second circuit boards 22, lighting units 23a and insulating housings 25 are disposed at one side of the carrier 26, and the first circuit board 21 is disposed at the other side of the carrier 26.

The material of the carrier 26 can be metal or alloy, and it has a reflective surface S with a size of 60cm×60cm or 60cm×120cm. The carrier 26 is connected to the insulating housings 25 through connecting members 261 and 251 by way of locking, wedging or hooking. In this embodiment, the carrier 26 is connected to the insulating housings 25 through the connecting members 261 and 251 by way of locking.

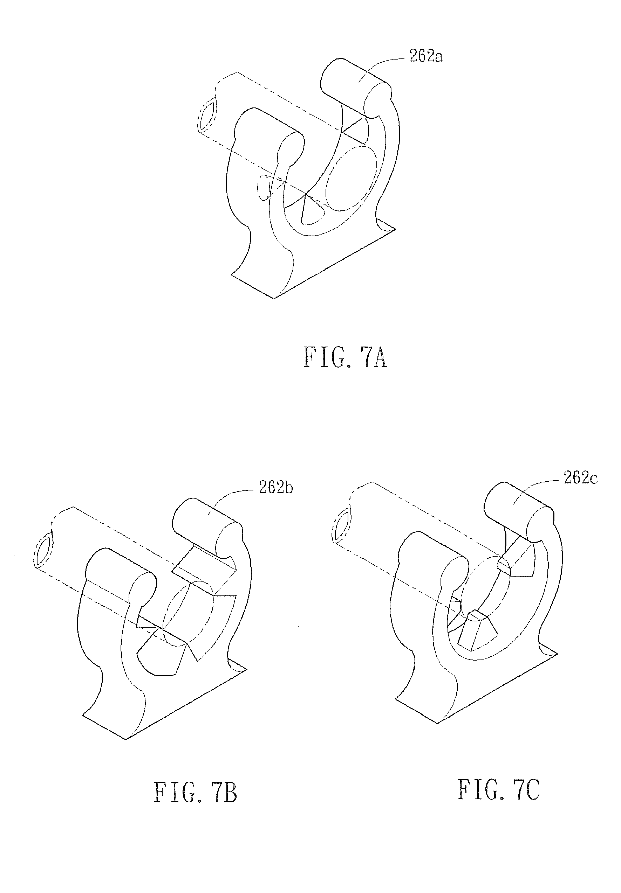

In addition, the carrier 26 may further include a holding member 262 for maintaining the relative positions of the lighting unit 23a and the carrier 26. Referring to FIG. 7A, the holding member 262a contacts the fluorescent lamp 232 in a point. Referring to FIG. 7B, the holding member 262b contacts the fluorescent lamp 232 in a line. Referring to FIG. 7C, the holding member 262c contacts the fluorescent lamp 232 in a surface. Since the contact areas between the fluorescent lamp 232 and the holding members 262a to 262c are smaller, the improper heat dissipation of the fluorescent lamp 232 caused by the holding members 262a to 262c can be prevented.

Referring to FIG. 6 again, since the carrier 26 can carry a plurality of lighting units 23a, the brightness of the illumination device 2c can be greatly increased. In addition, the carrier 26 can be easily installed at various kinds of environments, so the application scope of the illumination device 2c can be broadened. The reflective surface S of the carrier 26 can further efficiently increase the light utilization rate of the lighting unit 23a.

To be noted, the fluorescent lamp 232 of this aspect is, for example but not limited to, a U-shaped fluorescent lamp and, of course, it can be a C-shaped fluorescent lamp, W-shaped fluorescent lamp or a linear fluorescent lamp.

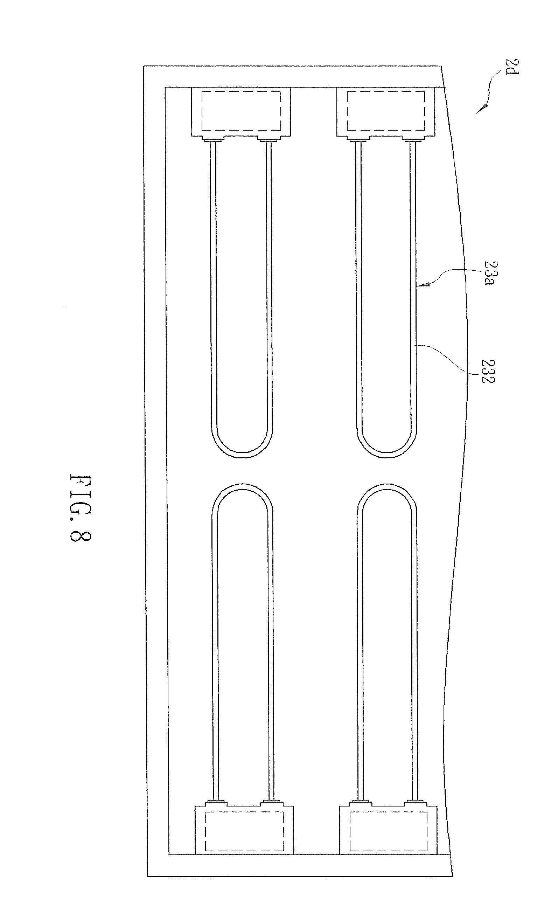

FIG. 8 is a schematic illustration showing an illumination device 2d, which is another aspect of the embodiment. In the illumination device 2d of FIG. 8, two fluorescent lamps 232 of different lighting units 23a can be arranged opposite to each other, so that the lighting units 23a can be closely configured. Accordingly, the number of the configured lighting units 23a can be increased so as to improving the brightness of the illumination device 2d.

To be noted, the fluorescent lamp 232 of this aspect is, for example but not limited to, a U-shaped fluorescent lamp and, of course, it can be a C-shaped fluorescent lamp, W-shaped fluorescent lamp or a linear fluorescent lamp.

### SECOND EMBODIMENT

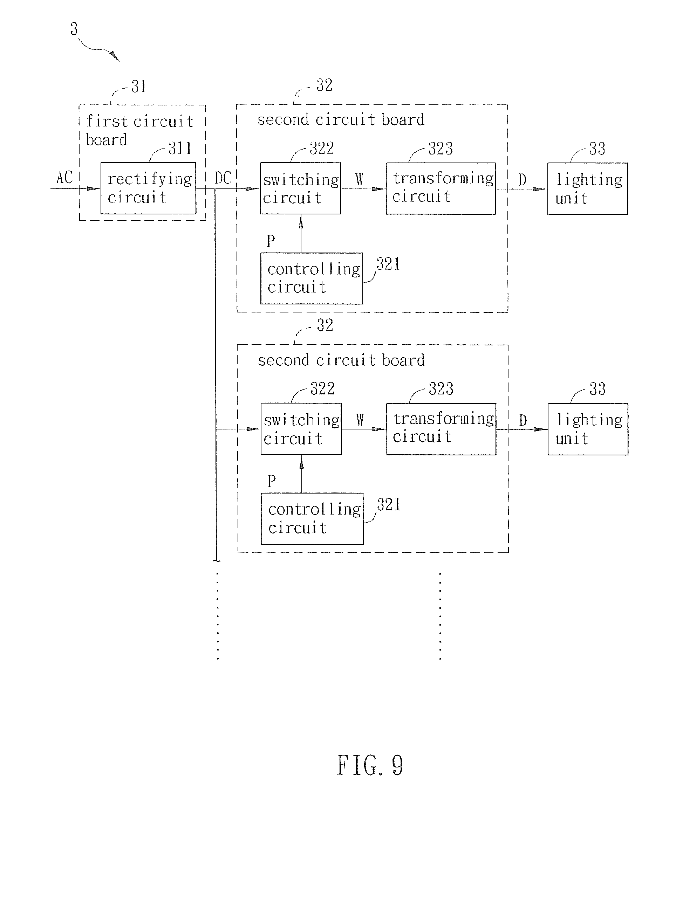

FIG. 9 is a block diagram showing an illumination device 3 according to a second embodiment of the present invention. The difference between the illumination device 3 and the illumination device 2 of the first embodiment is described as follow. The first circuit board 31 of the illumination device 3 includes only a rectifying circuit 311, and the second circuit board 32 includes a controlling circuit 321, a switching circuit 322 and a transforming circuit 323, which are electrically connected with each other. Similarly, the second circuit board 32 is electrically connected to the first circuit board 31, and the lighting unit 33 is electrically connected to the transforming circuit 323. In addition, the illumination device 3 of this embodiment includes, for example but not limited to, a plurality of second circuit boards 32 and lighting units 33.

In the embodiment, the rectifying circuit 311 generates a power source signal DC according to an inputted alternate-cunent power source signal AC, the switching circuit 322 receives the power source signal DC, and the controlling circuit 321 generates at least one control signal P according to the power source signal DC. The switching circuit 322 is opened or closed according to the control signal P generated by the controlling circuit 321, thereby outputting a power signal W. The transforming circuit 323 receives the power signal W and then generates a driving signal D to the lighting unit 33 for driving the lighting unit 33 to emit light.

In the illumination device 3 of this embodiment, the lighting unit 33 can be repaired or replaced by detaching the first and second circuit boards 31 and 32. This can avoid the user from contacting the driving signal D transmitted between the transforming circuit 323 and the lighting unit 33, so that the risk of electric shock during the replacement or repairing can be reduced. Moreover, since the replacement or repairing for the illumination device 3 can be performed by disconnecting or connecting the first and second circuit boards 31 and 32, the improper connection caused by improperly connecting or repeated replacement while directly replacing the lighting unit 33 can be prevented. This can further avoid the undesired arcing or electric leakage due to the driving signal D between the lighting unit 33 and the second circuit board 32, thereby enhancing the reliability of the illumination device 3.

Furthermore, in the illumination device 3 of the present embodiment, different circuits are separately configured at different circuit boards. This configuration can increase the efficiency of detecting the broken circuits. If only one circuit is damaged, it is not necessary to replace the entire circuit board, so that the maintain cost can be reduced.

To be noted, the structure of the illumination device 3 can be any of the structures shown in FIGS. 4A, 4B, 5A, 5B, 6, 7A, 7B, 7C and 8, whose features and functions are illustrated in the first embodiment, so the detailed description thereof will be omitted.

### THIRD EMBODIMENT

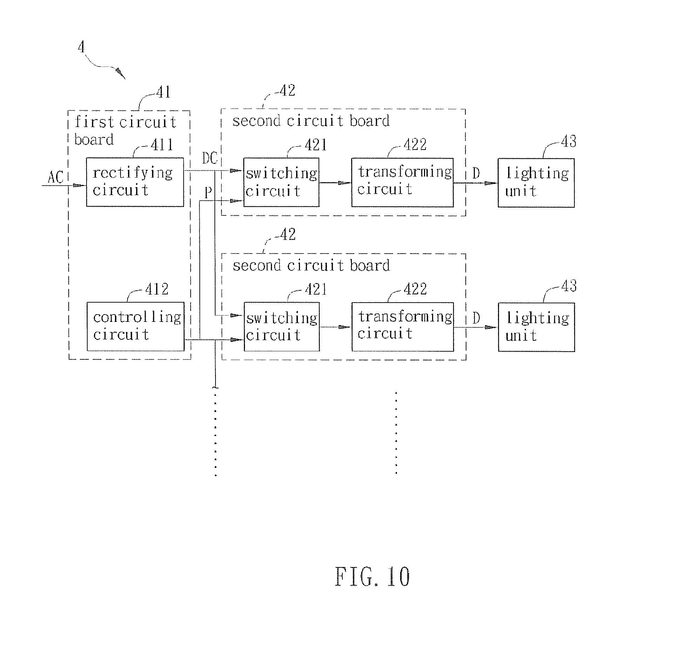

FIG. 10 is a block diagram showing an illumination device 4 according to a third embodiment of the present invention. The difference between the illumination device 4 and the illumination device 2 of the first embodiment is described as follow. The first circuit board 41 of the illumination device 4 includes a rectifying circuit 411 and a controlling circuit 412, which are electrically connected to each other, and the second circuit board 42 includes a switching circuit 421 and a transforming circuit 422, which are electrically connected with each other. Similarly, the second circuit board 42 is electrically connected to the first circuit board 41, and the lighting unit 43 is electrically connected to the transforming circuit 422.

In the embodiment, the rectifying circuit 411 generates a power source signal DC according to an inputted alternate-current power source signal AC, and the controlling circuit 412 generates at least one control signal P according to the power source signal DC. The switching circuit 421 is opened or closed according to the control signal P generated by the controlling circuit 412, thereby outputting a power signal W. The transforming circuit 422 receives the power signal W and then generates a driving signal D to the lighting unit 43 for driving the lighting unit 43 to emit light.

In the illumination device 4 of this embodiment, the lighting unit 43 can be repaired or replaced by detaching the first and second circuit boards 41 and 42. This can avoid the user from contacting the driving signal D transmitted between the transforming circuit 422 and the lighting unit 43, so that the risk of electric shock during the replacement or repairing can be reduced. Moreover, since the replacement or repairing for the illumination device 4 can be performed by disconnecting or connecting the first and second circuit boards 41 and 42, the improper connection caused by improperly connecting or repeated replacement while directly replacing the lighting unit 43 can be prevented. This can further avoid the undesired arcing or electric leakage due to the driving signal D between the lighting unit 43 and the second circuit board 42, thereby enhancing the reliability of the illumination device 4.

Furthermore, in the illumination device 4 of the present embodiment, different circuits are separately configured at different circuit boards. This configuration can increase the efficiency of detecting the broken circuits. If only one circuit is damaged, it is not necessary to replace the entire circuit board, so that the maintain cost can be reduced.

To be noted, the structure of the illumination device 4 can be any of the structures shown in FIGS. 4A, 4B, 5A, 5B, 6, 7A, 7B, 7C and 8, whose features and functions are illustrated in the first embodiment, so the detailed description thereof will be omitted.

In addition, the voltage values of the above-mentioned alteniate-current and direct-current power sources are for illustration only, and they can be adjusted according to different applications.

In summary, the lighting unit is electrically connected to the transforming circuit of the second circuit board, and then the second circuit board is electrically connected to the first circuit board. Thus, if the lighting unit is breakdown, the replacement or repairing of the broken lighting unit can be performed by simply detaching the second and first circuit boards. This can avoid the user from contacting the driving signal transmitted between the transforming circuit and the lighting unit, so that the risk of electric shock during the replacement or repairing can be reduced.

Moreover, since the replacement or repairing can be performed by disconnecting or connecting the first and second circuit boards, the improper connection caused by improperly connecting of the first and second circuit boards or repeated replacement while directly replacing the lighting unit can be prevented. This can further avoid the undesired arcing or electric leakage due to the driving signal between the lighting unit and the second circuit board, thereby enhancing the reliability of the illumination device.

Furthermore, in the illumination device of the present invention, different circuits are separately configured at different circuit boards. This configuration can increase the efficiency of detecting the broken circuits. If only one circuit is damaged, it is not necessary to replace the entire circuit board, so that the maintain cost can be reduced.

In addition, the illumination device of the present invention may further include a protection circuit for disabling the controlling circuit when the short circuit is happened between the first and second circuit boards. This can protect the illumination device from further damages as the switching circuit keeping outputting the power signal.

Moreover, the first and second circuit boards are connected through a connector, so that the efficiency of repairing or replacement of the illumination device can be sufficiently enhanced so as to increase the convenience thereof. In one aspect, the second circuit board is disposed in an insulating housing, so that the illumination device can be safer. In another aspect, the illumination device may further include a carrier for increasing the application scope thereof, and the reflective surface of the carrier can further increase the light utilization rate.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An illumination device, comprising:
a first circuit board having a controlling circuit, a switching circuit and a protection circuit, wherein the controlling circuit is electrically connected to the switching circuit and the protection circuit, respectively;
a second circuit board having a transforming circuit and electrically connected with the first circuit board; and
a lighting unit electrically connected to the transforming circuit.

2. The illumination device according to claim 1, wherein the first circuit board further comprises a rectifying circuit for generating a power source signal, and the switching circuit receives the power source signal.

3. An illumination device, comprising:
a first circuit board having a rectifying circuit;
a second circuit board electrically connected to the first circuit board and having a controlling circuit, a switching circuit and a transforming circuit electrically connected to each other; and
a lighting unit electrically connected to the transforming circuit.

4. The illumination device according to claim 1 or 3, wherein the controlling circuit generates at least one control signal, and the switching circuit is opened or closed according to the control signal for outputting a power signal.

5. An illumination device, comprising:
a first circuit board having a rectifying circuit and a controlling circuit electrically connected to each other;
a second circuit board electrically connected to the first circuit board and having a switching circuit and a transforming circuit electrically connected to each other; and
a lighting unit electrically connected to the transforming circuit.

6. The illumination device according to claim 3 or 5, wherein the rectifying circuit generates a power source signal, and the switching circuit receives the power source signal.

7. The illumination device according to claim 5, wherein the controlling circuit generates a control signal, and the switching circuit is opened or closed according to the control signal for outputting a power signal.

8. The illumination device according to claim 4 or 7, wherein the transforming circuit receives the power signal for generating a driving signal to the lighting unit.

9. The illumination device according to claim 1, 3 or 5, wherein the lighting unit is connected to the second circuit board by welding or through a conductive wire or a connector.

10. An illumination device, comprising:
a first circuit board having a rectifying circuit;
a second circuit board electrically connected to the first circuit board and having a transforming circuit; and
a lighting unit electrically connected to the transforming circuit.

11. The illumination device according to claim 1, 3, 5 or 10, further comprising:
an insulation housing, wherein at least one portion of the second circuit board is disposed in the insulation housing.
